# EUROPEAN PATENT APPLICATION

(11) **EP 4 142 013 A1**
(43) Date of publication of application: **01.03.2023**
(21) Application number: 21792255.8
(22) Date of filing: 21.04.2021
(51) Int. Cl.: H01M 10/42, G01R 31/379, G01R 31/396, H01M 10/06

(54) **LEAD STORAGE BATTERY MANAGEMENT SYSTEM**

(30) Priority: 22.04.2020 KR 20200048399
(71) Applicant: Ingine Inc., Seoul 02633 (KR)
(72) Inventor: CHOI, Jun Yong, Incheon 22003 (KR); SUNG, Yong Jun, Seoul 02023 (KR); OH, Sang Won, Seoul 02512 (KR)
(74) Representative: Biallo, Dario
(86) International application number: PCT/KR2021/004980
(87) International publication number: WO 2021/215810

(57) **Abstract**

A lead storage battery management system is disclosed. The lead storage battery management system according to an embodiment, comprises: a lead storage battery regeneration device for generating a pulse wave current to remove oxide films generated on electrodes of a lead storage battery; a measuring device for measuring information on the state of the lead storage battery; a control unit for controlling operations of the lead storage battery regeneration device and the measuring device; and an adjusting device interlocked with the control unit to receive, as an input, an operation value from a user, to thus improve the operation efficiency of the lead storage battery regeneration device, and to easily gain access to information stored in a database and operation state information of the lead storage battery regeneration device to easily control the operation of the lead storage battery regeneration device and the measuring device.

## Description

### Technical Field

The following description relates to a lead storage battery management system.

### Background Art

A lead storage battery is a rechargeable battery that uses lead as an electrode and sulfuric acid as an electrolyte and may be repeatedly used through charging and discharging. A lead storage battery may charge and discharge electrical energy therein through a process of generating and decomposing lead sulfate through reduction-oxidation generated in an electrode. In the course of charging and discharging a lead storage battery, if the battery is left discharged or not fully charged, sulfate is generated on an electrode plate. When there is sulfate on the electrode plate, the electrode plate may not be able to properly function as an electrode plate, and performance of the lead storage battery may deteriorate.

In order to prevent the performance of a lead storage battery from deteriorating due to the generation of sulfate, a strong voltage or current may be applied to an electrode surface of the lead storage battery such that a sulfate film generated on the electrode may be ionized into sulfate ions and lead ions. However, there are disadvantages. The lead storage battery may need to be separated from a product while the sulfate is being removed in the process of applying the strong voltage or current to the electrode surface. Moreover, measuring the lead storage battery and a lead storage battery reconditioning device and managing the lead storage battery may be difficult because an additional measuring instrument is needed to measure the state of the lead storage battery and an operation of a film-removing device. Therefore, there is a need for a system for extending the lifetime of a lead storage battery and effectively managing a lead storage battery.

In this regard, Korean Patent Publication No. 10-0868491 discloses a life continuation system and a method of an accumulator. A life continuation system and a method of an accumulator relate to a technology associated with a device for regenerating a storage battery to prevent crystallized sulfate from accumulating on an electrode plate through a chemical reaction using a pulse wave having a high frequency band.

The above description is information the inventor(s) acquired during the course of conceiving the present disclosure, or already possessed at the time, and is not necessarily art publicly known before the present application was filed.

### Disclosure of the Invention

### Technical Goals

An aspect provides a lead storage battery management system for improving operational efficiency of a lead storage battery reconditioning device by building a database in which information on lead storage battery management and by performing machine learning that repeatedly compares operation information of a reconditioning device according to lead storage battery information based on database information through the lead storage battery reconditioning device that removes an oxide film generated on an electrode of the lead storage battery, a measuring device that measures information on a state of the lead storage battery, and a controller that receives an operation signal from the lead storage battery reconditioning device and the measuring device to control an operation.

Another aspect provides a lead storage battery management system for allowing a user to easily access a state of a lead storage battery and information on an operation state of a lead storage battery reconditioning device and readily control operations of the lead storage battery and a measuring device through an adjusting device that is interlocked with a controller and receives operation values of the lead storage battery reconditioning device and the measuring device from the user.

### Technical Solutions

According to an aspect, there is provided a lead storage battery management system including a lead storage battery reconditioning device configured to generate a pulse wave current to remove an oxide film generated on an electrode of a lead storage battery, a measuring device configured to measure information on a state of the lead storage battery, a controller configured to receive an operation signal from the lead storage battery reconditioning device and the measuring device to control operations of the lead storage battery reconditioning device and the measuring device, and an adjusting device interlocked with the controller and configured to receive, from a user, operation values of the lead storage battery reconditioning device and the measuring device.

The measuring device may measure a degree of formation of the oxide film generated on the electrode of the lead storage battery, and the controller may determine an output amount of the lead storage battery reconditioning device based on a value of the degree of formation of the oxide film measured by the measuring device.

The measuring device may measure the degree of formation of the oxide film by measuring an internal voltage, internal resistance, a temperature, electrolyte density, and a charging level of the lead storage battery.

The controller may include a database configured to accumulate information measured by the measuring device, operation information of the lead storage battery reconditioning device, and information on the lead storage battery, a determiner configured to determine matters related to operations of the measuring device and the lead storage battery reconditioning device based on the information accumulated in the database, and an adjuster configured to adjust the operations of the measuring device and the lead storage battery reconditioning device based on a determination by the determiner.

A series of operations to store the operation information of the lead storage battery reconditioning device operated by the controller in the database may be repeated.

The controller may further include a machine learning module configured to derive an effective operation value of the lead storage battery reconditioning device by repeatedly comparing the operation information of the lead storage battery reconditioning device according to the information measured by the measuring device and state information of the lead storage battery based on the information stored in the database.

The adjusting device may include an input configured to receive, from a user, information on operation modes and operation values of the lead storage battery reconditioning device and the measuring device, and a display configured to visually display input information of the input, operation information of the lead storage battery reconditioning device, and information stored in the controller.

The adjusting device may receive the information on the operation modes and the operation values of the lead storage battery reconditioning device and the measuring device and visually display the operation information of the lead storage battery reconditioning device and the measuring device through at least one of an application and a wearable device interlocked with the controller through an Internet signal.

### Advantageous Effects

According to an example embodiment, a lead storage battery management system may improve operational efficiency of a lead storage battery reconditioning device by building a database in which information on lead storage battery management and by performing machine learning that repeatedly compares operation information of a reconditioning device according to lead storage battery information based on database information through the lead storage battery reconditioning device that removes an oxide film generated on an electrode of the lead storage battery, a measuring device that measures information on a state of the lead storage battery, and a controller that receives an operation signal from the lead storage battery reconditioning device and the measuring device to control an operation.

According to an example embodiment, a lead storage battery management system may allow a user to easily access a state of a lead storage battery and information on an operation state of a lead storage battery reconditioning device and readily control operation of the lead storage battery and a measuring device through an adjusting device that is interlocked with a controller and receives operation values of the lead storage battery reconditioning device and the measuring device from the user.

### Brief Description of Drawings

The accompanying drawings illustrate preferred example embodiments of the present disclosure, and are provided together with the detailed description for better understanding of the technical idea of the present disclosure. Therefore, the present disclosure should not be construed as being limited to the example embodiments set forth in the drawings.
FIG. 1 is a schematic view of a lead storage battery management system according to an example embodiment.
FIG. 2 is a block diagram illustrating a lead storage battery management system according to an example embodiment.

### Best Mode for Carrying Out the Invention

Hereinafter, embodiments will be described in detail with reference to the illustrative drawings. Regarding the reference numerals assigned to the components in the drawings, it should be noted that the same components will be designated by the same reference numerals, wherever possible, even though they are shown in different drawings. Also, in the description of the example embodiments, a detailed description of well-known related structures or functions will be omitted when it is deemed that such description will cause ambiguous interpretation of the present disclosure.

Also, in the description of the components, terms such as first, second, A, B, (a), (b) or the like may be used herein when describing components of the present disclosure. These terms are used only for the purpose of discriminating one constituent element from another constituent element, and the nature, the sequences, or the orders of the constituent elements are not limited by the terms. When one constituent element is described as being "connected", "coupled", or "attached" to another constituent element, it should be understood that one constituent element can be connected or attached directly to another constituent element, and an intervening constituent element can also be "connected", "coupled", or "attached" to the constituent elements.

The same name may be used to describe an element included in the example embodiments described above and an element having a common function. Unless otherwise mentioned, the descriptions of the examples may be applicable to the following examples and thus, duplicated descriptions will be omitted for conciseness.

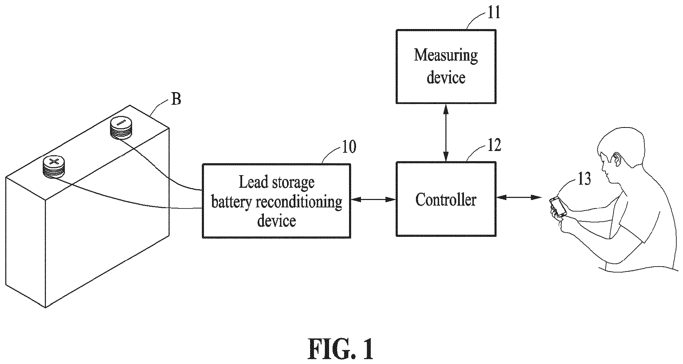

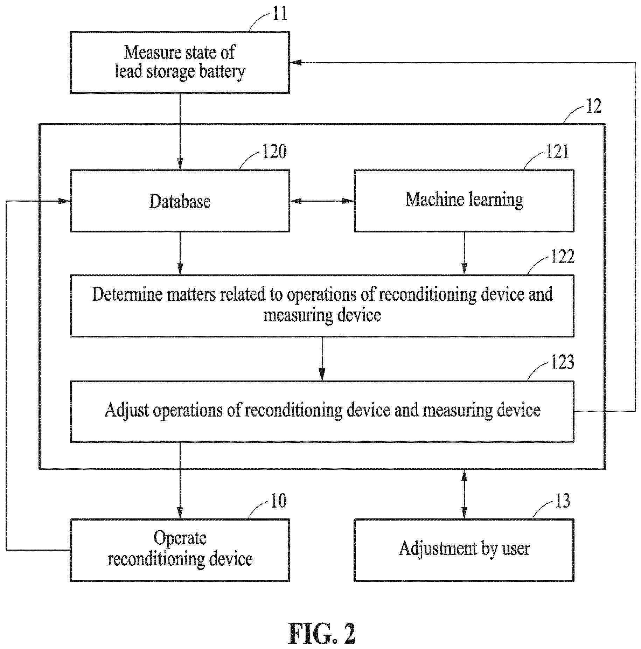

According to an example embodiment, FIG. 1 is a schematic view of a lead storage battery management system, and FIG. 2 is a block diagram illustrating a lead storage battery management system.

Referring to FIGS. 1 and 2, a lead storage battery management system 1 may extend a lifetime of a lead storage battery and provide a service for lifetime extension management to a user. The lead storage battery management system 1 may reduce lead usage and environmental damage caused by lead by extending the lifetime of the lead storage battery. The lead storage battery management system 1 may include a lead storage battery reconditioning device 10, a measuring device 11, a controller 12, and an adjusting device 13.

The lead storage battery reconditioning device 10 may generate a pulse wave current to remove an oxide film generated on an electrode of the lead storage battery. For example, the lead storage battery reconditioning device 10 may remove sulfate generated on the electrode using powerful pulse power. The lead storage battery reconditioning device 10 may remove the sulfate generated on the electrode of the lead storage battery by ionizing the lead sulfate generated on the electrode so that lead ions are stabilized and become lead in an original electrode state and enabling sulfate ions to return to an electrolyte state. The lead storage battery reconditioning device 10 may use pulse power falling within a range of 100 Hertz (Hz) to 990 Hz. The lead storage battery reconditioning device 10 may remove the sulfate by accumulating electrical energy in a condenser and instantaneously supplying a large amount of power to the electrode of the lead storage battery in a short time through switching.

In addition, the lead storage battery reconditioning device 10 may adjust a pulse power frequency, intensity of a pulse wave, and an amount of power to be used. Accordingly, the lead storage battery reconditioning device 10 may receive an operation control signal of the controller 12 to operate in an appropriate operation mode according to a circumstance, thereby increasing power efficiency and efficiently removing the oxide film of the lead storage battery.

The lead storage battery reconditioning device 10 may be coupled to the electrode of the lead storage battery. Therefore, the oxide film generated on the electrode of the lead storage battery may be removed by the lead storage battery reconditioning device 10 without an additional separation operation.

The measuring device 11 may measure information on a state of the lead storage battery. For example, the measuring device 11 may measure an internal voltage and an internal resistance of the lead storage battery. The measuring device 11 may measure electrolyte density in the lead storage battery. The measuring device 11 may measure a degree of formation of the oxide film generated on the electrode of the lead storage battery. The measuring device 11 may measure the degree of formation of the oxide film by measuring the internal voltage, the internal resistance, a temperature, the electrolyte density and a charging level of the lead storage battery.

The controller 12 may receive an operation signal from the lead storage battery reconditioning device 10 and the measuring device 11 to control operations of the lead storage battery reconditioning device 10 and the measuring device 11. For example, the controller 12 may perform a machine learning process of repeatedly analyzing operational efficiency of the lead storage battery reconditioning device 10 according to the state of the lead storage battery by storing operation information of the lead storage battery reconditioning device 10 and information measured by the measuring device 11. The controller 12 may determine matters related to the operations of the lead storage battery reconditioning device 10 and the measuring device 11 based on information on the analysis obtained through the machine learning process to control the operations of the lead storage battery reconditioning device 10 and the measuring device 11. The controller 12 may include a database 120, a machine learning module 121, a determiner 122, and an adjuster 123.

The database 120 may accumulate the information measured by the measuring device 11, the operation information of the lead storage battery reconditioning device 10, and information on the lead storage battery. For example, the database 120 may store the information on the lead storage battery such as serial number, a model name, capacitance, and performance efficiency of the lead storage battery. The database 120 may store information on the state of the lead storage battery such as a voltage, an output amount, an oxide film thickness, and high reconditioning efficiency of the lead storage battery. The database 120 may store information on the operation of the lead storage battery reconditioning device 10 such as a pulse power frequency, a reconditioning time, and an amount of oxide film removed from the lead storage battery. The database 120 may store information received by the adjusting device 13 from the user.

The machine learning module 121 may derive an effective operation value of the lead storage battery reconditioning device 10 by repeatedly comparing the operation information of the lead storage battery reconditioning device 10 according to the information measured by the measuring device 11 and the state information of the lead storage battery based on the information stored in the database 120. For example, the machine learning module 121 may repeatedly learn a reconditioning scheme of the lead storage battery reconditioning device 10, such as an appropriate pulse power frequency and the output amount, according to the model name of the lead storage battery, the thickness of the oxide film generated in the lead storage battery, and the internal voltage and internal resistance of the lead storage battery stored in the database 120. Therefore, a more efficient and appropriate reconditioning scheme of the lead storage battery reconditioning device 10 may be determined through repeated learning performed by the machine learning module 121.

The determiner 122 may determine matters related to the operations of the measuring device 11 and the lead storage battery reconditioning device 10 based on the information accumulated in the database 120. In addition, the determiner 122 may determine matters related to the operations of the measuring device 11 and the lead storage battery reconditioning device 10 based on the information analyzed by the machine learning module 121. For example, the determiner 122 may determine a measurement frequency of the measuring device 11, a measurement mode of the measuring device 11, the appropriate pulse power frequency of the lead storage battery reconditioning device 10, the intensity of the pulse wave, and power consumption, and the like, based on the information accumulated in the database 120 and the information analyzed by the machine learning module 121.

The adjuster 123 may adjust the operations of the measuring device 11 and the lead storage battery reconditioning device 10 based on a determination by the determiner 122. For example, the adjuster 123 may adjust the measurement frequency, measurement mode, and the like, of the measuring device 11. The adjuster 123 may adjust the pulse power frequency, the intensity of the pulse wave, the power consumption, and the like, of the lead storage battery reconditioning device 10. The adjuster 123 may adjust an electrical energy charging level and a charging or discharging state of the lead storage battery.

A series of operations to store the operation information of the lead storage battery reconditioning device 10 operated by the adjuster 123 in the database 120 may be repeated. For example, the database 120 may store the operation information of the lead storage battery reconditioning device 10 according to the state information and the performance information of the lead storage battery. The database 120 may provide information to be referenced and used during reconditioning operations that sequentially occur by building a shared server that stores the operation information of the lead storage battery reconditioning device 10 according to the information of the lead storage battery.

The measuring device 11 may measure the thickness of the oxide film generated on the electrode of the lead storage battery, and the controller 12 may determine the output amount of the lead storage battery reconditioning device 10 based on a value of the thickness of the oxide film measured by the measuring device 11.

The adjusting device 13 may be interlocked with the controller 12 and receive operation values of the lead storage battery reconditioning device 10 and the measuring device 11 from the user. The adjusting device 13 may include an input and a display.

The input may receive information on the operation values and operation modes of the lead storage battery reconditioning device 10 and the measuring device 11 from the user. For example, the input may include a charging mode of the lead storage battery, the measurement mode of the measuring device 11, and a reconditioning mode of the lead storage battery reconditioning device 10. In addition, the input may also receive basic information such as serial number of the lead storage battery, serial number of the lead storage battery reconditioning device 10, serial number of the measuring device 11, and the like.

The display may visually display input information of the input, the operation information of the lead storage battery reconditioning device 10, and information stored in the controller 12. For example, the display may

The adjusting device 13 may receive the information on operation modes and operation values of the lead storage battery reconditioning device 10 and the measuring device 11 and visually display the operation information of the lead storage battery reconditioning device 10 and the measuring device 11 through at least one of an application and a wearable device interlocked with the controller 12 through an Internet signal.

A number of example embodiments have been described above. Nevertheless, it should be understood that various modifications may be made to these example embodiments. For example, suitable results may be achieved if the described techniques are performed in a different order and/or if components in a described system, architecture, device, or circuit are combined in a different manner and/or replaced or supplemented by other components or their equivalents.

## Claims

1. A lead storage battery management system comprising:
a lead storage battery reconditioning device configured to generate a pulse wave current to remove an oxide film generated on an electrode of a lead storage battery;
a measuring device configured to measure information on a state of the lead storage battery;
a controller configured to receive an operation signal from the lead storage battery generation device and the measuring device to control operations of the lead storage battery reconditioning device and the measuring device; and
an adjusting device interlocked with the controller and configured to receive, from a user, operation values of the lead storage battery reconditioning device and the measuring device.

2. The lead storage battery management system of claim 1, wherein the measuring device is configured to measure a degree of formation of the oxide film generated on the electrode of the lead storage battery, and the controller is configured to determine an output amount of the lead storage battery generation device based on a value of the degree of formation of the oxide film measured by the measuring device.

3. The lead storage battery management system of claim 2, wherein the measuring device is configured to measure the degree of formation of the oxide film by measuring an internal voltage, internal resistance, a temperature, electrolyte density, and a charging level of the lead storage battery.

4. The lead storage battery management system of claim 1, wherein the controller comprises:
a database configured to accumulate information measured by the measuring device, operation information of the lead storage battery reconditioning device, and information on the lead storage battery;
a determiner configured to determine matters related to operations of the measuring device and the lead storage battery reconditioning device based on the information accumulated in the database; and
an adjuster configured to adjust operations of the measuring device and the lead storage battery reconditioning device based on a determination by the determiner.

5. The lead storage battery management system of claim 4, wherein a series of operations to store the operation information of the lead storage battery reconditioning device operated by the controller in the database is repeated.

6. The lead storage battery management system of claim 4, wherein the controller further comprises:
a machine learning module configured to derive an effective operation value of the lead storage battery reconditioning device by repeatedly comparing the operation information of the lead storage battery reconditioning device according to the information measured by the measuring device and state information of the lead storage battery based on the information stored in the database.

7. The lead storage battery management system of claim 1, wherein the adjusting device comprises:
an input configured to receive, from a user, information on operation modes and operation values of the lead storage battery reconditioning device and the measuring device; and
a display configured to visually display input information of the input, operation information of the lead storage battery reconditioning device, and information stored in the controller.

8. The lead storage battery management system of claim 7, wherein the adjusting device is configured to receive the information on the operation modes and the operation values of the lead storage battery reconditioning device and the measuring device and visually display the operation information of the lead storage battery reconditioning device and the measuring device through at least one of an application and a wearable device interlocked with the controller through an Internet signal.
